**Europäisches Patentamt**

**European Patent Office**

**Office européen des brevets**

(11) Numéro de publication: **0 092 464**
**B1**

(12) FASCICULE DE BREVET EUROPEEN

(45) Date de publication du fascicule du brevet:
**24.07.85**

(21) Numéro de dépôt: **83400722.1**

(22) Date de dépôt: **12.04.83**

(51) Int. Cl.⁴: **H 03 K 21/40**

(54) **Compteur avec sauvegarde non-volatile de son contenu.**

(30) Priorité: **20.04.82 FR 8206755**

(43) Date de publication de la demande:
**26.10.83 Bulletin 83/43**

(45) Mention de la délivrance du brevet:
**24.07.85 Bulletin 85/30**

(84) Etats contractants désignés:
**CH DE FR GB IT LI NL**

(56) Documents cités:
**EP - A - 0 067 925**
**FR - A - 2 342 536**
**US - A - 3 760 372**
**US - A - 3 950 737**

(73) Titulaire: **SOCIETE POUR L'ETUDE ET LA FABRICATION DE CIRCUITS INTEGRES SPECIAUX - E.F.C.I.S.,**
**17, avenue des Martyrs, F-38100 Grenoble (FR)**

(72) Inventeur: **Brice, Jean-Michel, THOMSON-CSF**
**SCPI 173, bld Haussmann, F-75379 Paris Cedex 08 (FR)**

(74) Mandataire: **Guérin, Michel et al, THOMSON-CSF**
**SCPI 173, Bld Haussmann, F-75379 Paris Cédex 08 (FR)**

ACTORUM AG

# Description

La présente invention concerne un circuit électronique de comptage, et plus particulièrement un compteur recevant des impulsions de comptage et réalisé de telle manière que le contenu du compteur soit conservé en mémoire de manière non volatile, c'est-à-dire de manière que ce contenu ne soit pas perdu lors d'une coupure de l'alimentation électrique du compteur.

On peut réaliser un tel compteur à l'aide de bascules synchrones pourvues de circuits de sauvegarde: en fonctionnement normal, ces bascules changent d'état en fonction de leurs signaux d'entrée sous la commande d'un signal d'horloge; une commande de sauvegarde est prévue pour sauvegarder de manière non volatile l'état de la bascule; après une coupure d'alimentation, on peut repositionner la bascule dans l'état gardé en mémoire soit de manière automatique, soit grâce à une commande de repositionnement.

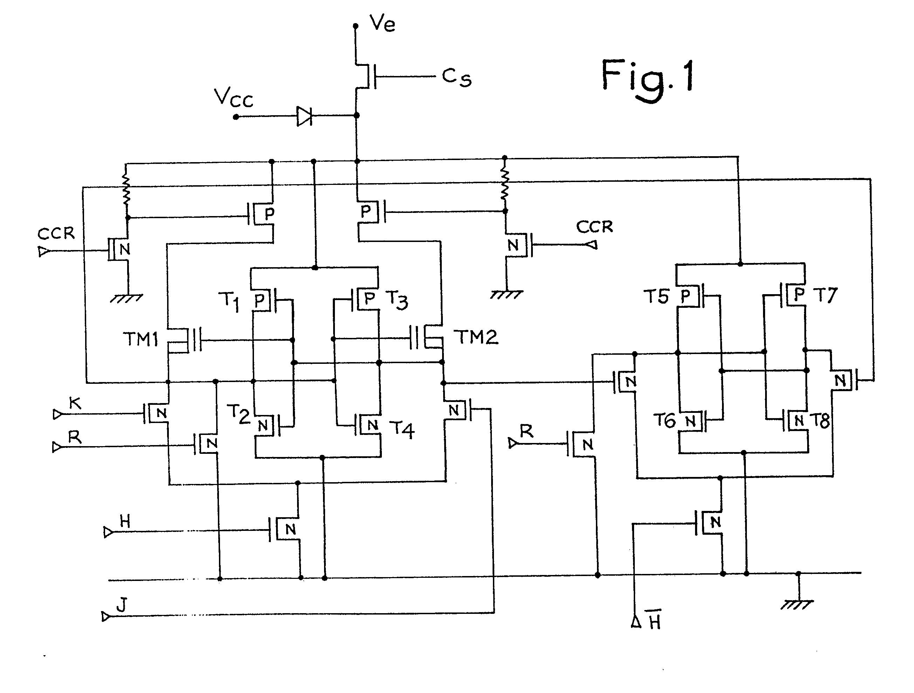

Un exemple de bascule bistable synchrone, à circuit de sauvegarde et à repositionnement commandé, est représenté à la fig. 1. Il s'agit d'une bascule JK maître-esclave comportant une entrée J, une entrée K, des entrées d'horloge H et H* (l'astérisque indiquant le signal complémentaire d'un signal donné), une entrée de remise à zéro forcée R et une entrée de commande de repositionnement CCR. La bascule elle-même se compose essentiellement de transistors T1, T2, T3, T4 (bascule-maître) et de transistors T5, T6, T7, T8 (bascule-esclave). Le circuit de sauvegarde comprend essentiellement deux transistors de type MNOS (Métal-Nitrure-Oxyde-Semiconducteur) TM1 et TM2, capables de conserver de manière non volatile des charges électriques piégées qui les rendent soit conducteurs, soit bloqués.

La sauvegarde de l'état de la bascule s'effectue grâce à un signal de commande de sauvegarde Cs qui permet d'appliquer à la bascule une tension d'écriture Ve plus élevée que la tension normale de fonctionnement (Vcc) en même temps qu'on isole les drains des transistors MNOS, TM1 et TM2, de la ligne d'alimentation grâce à un signal bas (0 V) appliqué à l'entrée de commande CCR. Les sources des transistors TM1 et TM2, reliées aux sorties de la bascule-maître, sont portées soit à 0 V, soit à la tension d'écriture Ve, selon l'état de la bascule.

Les transistors TM1 et TM2 prennent un état de conduction ou de blocage forcé permanent qui dépend directement de l'état de la bascule à l'instant où le signal Cs a été appliqué.

Le repositionnement de l'état de la bascule s'effectue aussi grâce à la commande CCR (état haut) qui relie les transistors MNOS, TM1 et TM2 à la ligne d'alimentation pour forcer la bascule-maître dans un état lié à l'état de blocage ou de conduction des transistors TM1 et TM2. La bascule retrouve alors l'état qu'elle avait lors de la sauvegarde.

Le circuit de la fig. 1 n'est donné qu'à titre d'exemple pour illustrer le fonctionnement d'une bascule bistable à circuit de sauvegarde et de repositionnement. D'autres bascules peuvent être conçues: bascules D et non JK; circuits de sauvegarde à transistors à grille flottante et non à transistors MNOS, etc.

Dans certaines applications de comptage, on souhaite garder en mémoire non volatile, à chaque instant, le contenu du compteur: par exemple, on peut compter la durée ou le nombre de cycles de fonctionnement d'un appareil, alors que ce fonctionnement est par nature intermittent et que l'alimentation de l'appareil (et donc du compteur) est coupée après chaque usage. Dans ces conditions, il faut prévoir systématiquement après chaque incrémentation du compteur une étape de sauvegarde (le mot incrémentation sera pris ci-après au sens large d'incrémentation ou décrémentation, étant entendu que l'invention s'applique à un compteur ou un décompteur ou un compteur-décompteur).

Malheureusement, les transistors MNOS ou les transistors à grille flottante, qui constituent les éléments de base des circuits de sauvegarde, ne peuvent supporter qu'un nombre limité de cycles d'écriture, après quoi ils se détériorent progressivement et n'arrivent plus à piéger convenablement les charges électriques qui assurent leur état de conduction ou blocage forcé. Il se produit alors d'une part une réduction de la rétention de l'information mise en mémoire et d'autre part un risque d'erreur de repositionnement dû à la modification des tensions de seuil de blocage des transistors après un grand nombre de cycles d'écriture.

Le nombre de cycles qu'on ne peut dépasser semble être de $10^5$ à $10^6$ pour des dispositifs MNOS et on devrait donc exclure les applications où l'on a besoin de faire fonctionner le compteur sur un nombre de cycles de cet ordre.

Pour augmenter le nombre maximum d'incrémentations que peut subir le compteur tout en effectuant une sauvegarde de son contenu à chaque incrémentation, la présente invention propose une unité de comptage constituée par une boucle de plusieurs bascules dont les sorties représentent sous forme binaire le contenu de l'unité de comptage selon un code particulier dans lequel aucun chiffre binaire ne change plus de deux fois au cours d'un cycle de comptage complet de l'unité; un moyen d'activation sélectif de la mise en mémoire non volatile des états des sorties des bascules est prévu et un circuit logique de sélection est couplé à ce moyen d'activation pour interdire l'activation de la mise en mémoire de l'état des bascules qui n'ont pas changé d'état après une incrémentation de l'unité du comptage et pour autoriser l'activation de la mise en mémoire de l'état des bascules qui ont changé d'état après cette incrémentation.

Ainsi, au lieu de réaliser le compteur sous forme classique avec des bascules agencées pour compter normalement selon le code binaire pur ou un code dit BCD (décimal codé binaire), ce qui est le plus courant pour des compteurs destinés à donner une représentation de nombres décimaux, on prévoit un code inhabituel qui est de préférence le code dit de «Johnson» que l'on explicitera ci-après, ou un code similaire du point de vue du nombre réduit de changements de chaque chiffre binaire au cours d'un cycle complet de comptage. De plus, lors de la sauvegarde du contenu du compteur, à chaque incrémentation, on n'effectue la sauvegarde que pour les bascules qui viennent de changer d'état.

Ces deux caractéristiques, faible nombre de changements d'état des bascules et sélection des bascules dont le contenu est à sauvegarder après un changement d'état, contribuent à réduire le nombre de cycles d'écriture de chacune des bascules et donc à augmenter la durée de vie globale du compteur.

On a utilisé le mot unité de comptage étant entendu qu'un compteur peut comporter plusieurs unités de comptage correspondant chacune à des chiffres de poids différents du résultat du comptage; par exemple un compteur décimal à quatre chiffres (0 à 9999) comportera quatre unités de comptage en cascade qui seront quatre décades de comptage. Chaque décade a un cycle complet de comptage de 10 incrémentations successives. Mais on pourrait envisager un compteur affichant un résultat hexadécimal à quatre chiffres (0000 à FFFF) et chaque unité de comptage effectuerait alors un cycle de comptage de seize incrémentations.

L'important est qu'une unité de comptage prise individuellement possède plusieurs sorties (les sorties des bascules de la boucle constituant cette unité) et que ces sorties définissent sous la forme de plusieurs chiffres binaires un résultat numérique de comptage à un chiffre (0 à 9 pour une décade en décimal) selon un code binaire spécial où chaque chiffre binaire ne change que deux fois au maximum au cours d'un cycle (0 à 9 en décimal).

Le choix du code Johnson est particulièrement intéressant car il remplit cette condition et parce qu'il permet comme on le verra de réaliser un circuit logique combinatoire particulièrement simple pour repérer, après une incrémentation du compteur, donc après chaque impulsion de comptage, quelles sont les bascules qui doivent subir un cycle d'écriture (deux bascules à chaque impulsion de comptage), en fonction de l'état des sorties des bascules et éventuellement en fonction de l'existence d'un signal de remise à zéro générale de l'unité de comptage ou du compteur.

D'autres caractéristiques et avantages de l'invention apparaîtront à la lecture de la description détaillée qui suit et qui est faite en référence aux dessins annexés dans lesquels:

la fig. 1, déjà décrite, représente une bascule bistable à circuit de sauvegarde non volatile, pouvant servir à la réalisation d'un compteur,

la fig. 2 représente une unité de comptage selon l'invention,

les fig. 3 et 4 représentent deux exemples d'agencement de bascules pour compter selon le code Johnson.

Il est tout à fait usuel de réaliser des unités de comptage d'un chiffre décimal ou hexadécimal à partir de quatre bascules JK ou quatre bascules D et éventuellement quelques portes. Les sorties des bascules constituent les sorties de l'unité de comptage et les bascules sont couplées les unes aux autres selon un schéma en boucle fermée de telle manière que l'état (binaire) des sorties des bascules représente cycliquement la succession des chiffres 0 à 9 codés selon un code choisi.

Par exemple, le code peut être binaire pur; si les sorties des quatre bascules sont A, B, C, D dans l'ordre des poids décroissants, le code de comptage en binaire pur de 0 à 15 est défini par les états successifs suivants des bascules pour chaque contenu de l'unité de comptage:

| | A | B | C | D | | A | B | C | D |
|---|---|---|---|---|---|---|---|---|---|
| 0 | 0 | 0 | 0 | 0 | 8 | 1 | 0 | 0 | 0 |
| 1 | 0 | 0 | 0 | 1 | 9 | 1 | 0 | 0 | 1 |
| 2 | 0 | 0 | 1 | 0 | 10 | 1 | 0 | 1 | 0 |
| 3 | 0 | 0 | 1 | 1 | 11 | 1 | 0 | 1 | 1 |
| 4 | 0 | 1 | 0 | 0 | 12 | 1 | 1 | 0 | 0 |
| 5 | 0 | 1 | 0 | 1 | 13 | 1 | 1 | 0 | 1 |
| 6 | 0 | 1 | 1 | 0 | 14 | 1 | 1 | 1 | 0 |
| 7 | 0 | 1 | 1 | 1 | 15 | 1 | 1 | 1 | 1 |
| | | | | | (16) | 0 | 0 | 0 | 0 |

Pour un comptage décimal (0 à 9) en code BCD, les sorties des bascules reviennent à 0 à la dixième impulsion de comptage:

| | A | B | C | D | | A | B | C | D |
|---|---|---|---|---|---|---|---|---|---|
| 0 | 0 | 0 | 0 | 0 | 5 | 0 | 1 | 0 | 1 |
| 1 | 0 | 0 | 0 | 1 | 6 | 0 | 1 | 1 | 0 |
| 2 | 0 | 0 | 1 | 0 | 7 | 0 | 1 | 1 | 1 |
| 3 | 0 | 0 | 1 | 1 | 8 | 1 | 0 | 0 | 0 |
| 4 | 0 | 1 | 0 | 0 | 9 | 1 | 0 | 0 | 1 |
| | | | | | (10) | 0 | 0 | 0 | 0 |

Pour ces deux codes très courants, on voit que les sorties de la dernière bascule (sortie D) changent d'état à chaque incrémentation. Si l'on veut sauvegarder de manière non volatile le contenu du compteur après chaque incrémentation, il faudrait réinscrire à chaque fois le contenu de la dernière bascule.

On propose ici d'utiliser un code de comptage différent (aboutissant donc à un couplage de bascule différent) qui est rarement utilisé car il nécessite cinq bascules au lieu de quatre pour un comptage décimal (0 à 9) et huit bascules au lieu de quatre pour un comptage hexadécimal (0 à 15).

Ce code est le suivant en décimal (les sorties des cinq bascules étant notées A, B, C, D, E):

| | A | B | C | D | E | | A | B | C | D | E |
|---|---|---|---|---|---|---|---|---|---|---|---|
| 0 | 0 | 0 | 0 | 0 | 0 | 5 | 1 | 1 | 1 | 1 | 1 |
| 1 | 1 | 0 | 0 | 0 | 0 | 6 | 0 | 1 | 1 | 1 | 1 |
| 2 | 1 | 1 | 0 | 0 | 0 | 7 | 0 | 0 | 1 | 1 | 1 |
| 3 | 1 | 1 | 1 | 0 | 0 | 8 | 0 | 0 | 0 | 1 | 1 |
| 4 | 1 | 1 | 1 | 1 | 0 | 9 | 0 | 0 | 0 | 0 | 1 |
| | | | | | | (10) | 0 | 0 | 0 | 0 | 0 |

Il convient de noter que le brevet EP-A2 N° 0067925, qui fait partie de l'état de la technique telle que définie à l'article 54(3) de la CBE, décrit une unité de comptage non volatile utilisant le même code.

Ce code est appelé code Johnson; l'intérêt qu'il présente habituellement est le fait qu'on passe d'un nombre au nombre immédiatement suivant par le changement d'un seul chiffre binaire (donc d'une seule sortie de bascule) et que ce changement se fait successivement d'une bascule à la suivante (contrairement au code Gray par exemple où un seul chiffre binaire change bien à chaque incrémentation mais ce chiffre n'est pas pris successivement sur chacune des bascules). Il en résulte une possibilité de décodage particulièrement simple pour restituer une information décimale sur le contenu du compteur.

Ce code Johnson est toutefois choisi ici pour une autre raison qui s'ajoute à la raison de simplicité du décodage et qui est le fait que chaque chiffre binaire ne change que deux fois au cours d'un cycle complet de comptage de 0 à 10 (il en serait de même en hexadécimal avec huit bascules, l'algorithme d'écriture du code en hexadécimal étant le même qu'en décimal).

Ainsi, la bascule dont la sortie est A ne change d'état que pour un passage du compteur de 0 à 1 ou de 5 à 6; de même la bascule dont la sortie est B ne change d'état que pour un passage du compteur de 1 à 2 ou de 6 à 7.

Non seulement il en résulte qu'on peut sauvegarder le contenu du compteur en n'effectuant une étape d'écriture que pour une seule bascule après chaque incrémentation (ce serait le cas avec l'utilisation d'un code Gray), mais encore la sauvegarde de l'état d'une même bascule n'est nécessaire que deux fois par cycle; enfin, la sélection de la bascule dont l'état est à sauvegarder (parce qu'il vient de changer) peut se faire avec un circuit logique combinatoire très simple qui peut se définir à l'aide de la table de vérité suivante où Ca, Cb, Cc, Cd, Ce sont des signaux de commande logiques indiquant, respectivement pour chaque bascule, si la sauvegarde doit être effectuée: par exemple Ca = 1 pour un contenu de compteur égal à 1 ou 6 et Ca = 0 pour les autres contenus; Cb = 1 pour un contenu égal à 2 ou 7 et Cb = 0 pour les autres contenus. Ca, Cb, Cc, Cd, Ce représentent donc des signaux de commande de sauvegarde de chaque bascule.

| | A | B | C | D | E | | Ca | Cb | Cc | Cd | Ce |
|---|---|---|---|---|---|---|---|---|---|---|---|
| 0 | 0 | 0 | 0 | 0 | 0 | 0 | • | • | • | • | • |
| 1 | 1 | 0 | 0 | 0 | 0 | 1 | 1 | 0 | 0 | 0 | 0 |
| 2 | 1 | 1 | 0 | 0 | 0 | 2 | 0 | 1 | 0 | 0 | 0 |
| 3 | 1 | 1 | 1 | 0 | 0 | 3 | 0 | 0 | 1 | 0 | 0 |
| 4 | 1 | 1 | 1 | 1 | 0 | 4 | 0 | 0 | 0 | 1 | 0 |
| 5 | 1 | 1 | 1 | 1 | 1 | 5 | 0 | 0 | 0 | 0 | 1 |
| 6 | 0 | 1 | 1 | 1 | 1 | 6 | 1 | 0 | 0 | 0 | 0 |
| 7 | 0 | 0 | 1 | 1 | 1 | 7 | 0 | 1 | 0 | 0 | 0 |
| 8 | 0 | 0 | 0 | 1 | 1 | 8 | 0 | 0 | 1 | 0 | 0 |
| 9 | 0 | 0 | 0 | 0 | 1 | 9 | 0 | 0 | 0 | 1 | 0 |
| (10) | 0 | 0 | 0 | 0 | 0 | (10) | 0 | 0 | 0 | 0 | 1 |

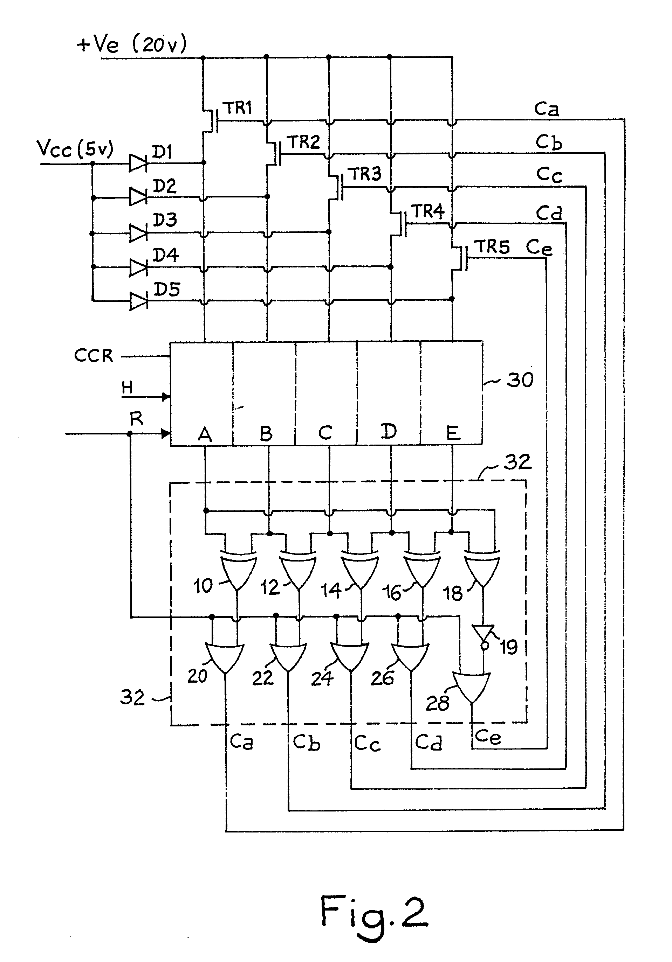

Le circuit logique permettant d'engendrer les commandes de sauvegarde de chaque bascule reçoit comme entrées les sorties A, B, C, D, E des bascules et possède cinq sorties Ca, Cb, Cc, Cd, Ce. Ce circuit, qui correspond au bloc en pointillés 32 de la fig. 2, se déduit de la table de vérité ci-dessus; Ca est formé essentiellement par un circuit d'anticoïncidence recevant A et B (porte OU-exclusif 10); Cb par un circuit d'anticoïncidence recevant B et C (porte OU-exclusif 12); Cc par un circuit d'anticoïncidence recevant C et D (porte OU-exclusif 14); Cd par un circuit d'anticoïncidence recevant D et E (porte OU-exclusif 16), et Ce par un circuit de coïncidence recevant E et A (porte OU-exclusif 18 suivie d'un inverseur 19).

En outre, on souhaite qu'il y ait sauvegarde du contenu du compteur en cas de remise à 0 et, pour que cette sauvegarde soit générale pour toutes les bascules quel que soit l'état précédent du compteur, on place en aval de la sortie des circuits de coïncidence et d'anticoïncidence des portes OU simples respectives 20, 22, 24, 26, 28 recevant chacune sur une entrée la sortie d'un de ces circuits et sur l'autre le signal commun R de remise à 0 du compteur. Il y a alors sauvegarde systématique du contenu 00000 du compteur lorsque ce contenu est dû au signal R. Au contraire, il n'y a sauvegarde que de la dernière bascule (sortie E) lorsque le passage à 00000 est dû à l'incrémentation à partir d'un contenu égal à 9 (00001).

On peut alors décrire l'ensemble d'une décade de comptage selon l'invention, représentée à la fig. 2, comprenant essentiellement une unité de comptage proprement dite 30 et un circuit logique de sélection 32 correspondant au bloc pointillé de la fig. 2.

L'unité de comptage proprement dite comprend cinq bascules (sorties A, B, C, D, E) et les circuits de sauvegarde associés.

Une entrée de comptage H est représentée ainsi qu'une entrée R de remise à 0 générale des bascules et une entrée de commande de repositionnement CCR.

Une tension d'alimentation Vcc, par exemple de 5 V, est appliquée normalement à chacune des bascules, mais une tension d'écriture plus élevée Ve (par exemple une vingtaine de volts) peut être appliquée sélectivement à chacune des bascules à la place de la tension Vcc grâce à des transistors MOS individuels TR1 à TR5 commandés respectivement par les signaux de commande de sauvegarde Ca, Cb, Cc, Cd, Ce. Les grilles de ces transistors correspondent à l'entrée de commande de sauvegarde Cs de la fig. 1.

Ces signaux sont issus des cinq sorties du circuit logique de sélection déjà décrit, désigné par la référence 32.

Des diodes D1 à D5 servent à empêcher la transmission de l'alimentation Ve vers l'alimentation Vcc lorsqu'un transistor TR1 à TR5 est conducteur.

Les transistors TR1 à TR5 et les diodes constituent l'essentiel du moyen d'activation (sélectif) de la mise en mémoire de l'état de chaque bascule. La commande CCR de l'unité de comptage doit être à 0 V pendant que la tension d'écriture Ve est appliquée; la durée d'application de cette dernière est limitée à 10 à 100 ms par exemple.

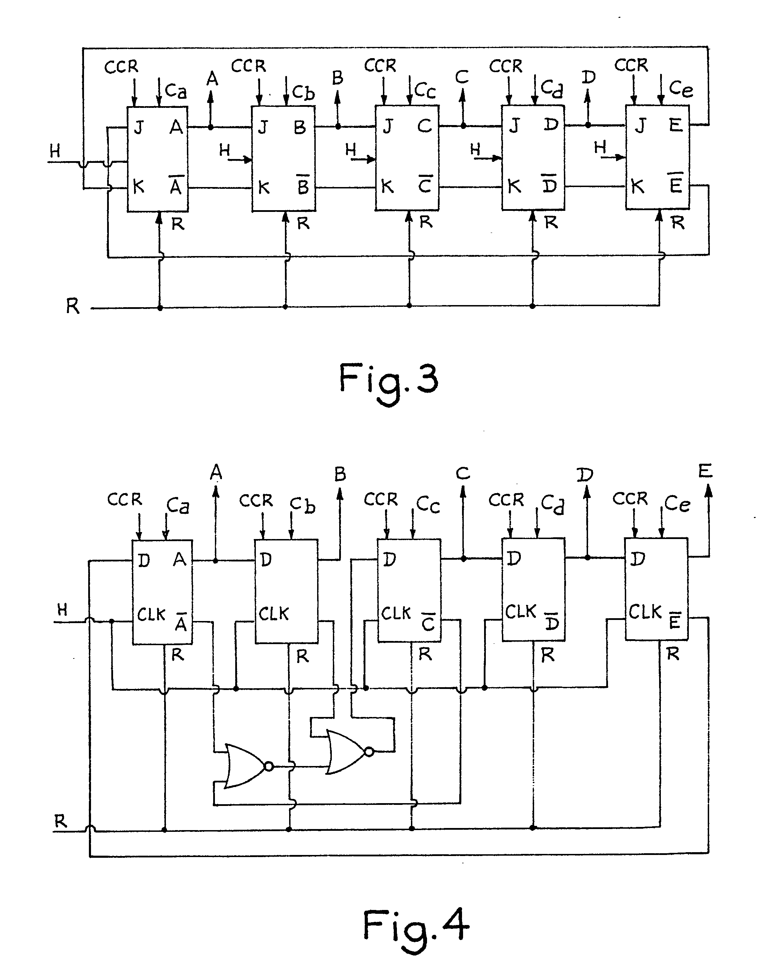

A la fig. 3, on a représenté à titre d'exemple quel pouvait être le couplage des cinq bascules JK d'une décade de comptage pour obtenir des sorties A, B, C, D, E de bascules représentant le nombre d'incrémentation de la décade selon le code de Johnson: les bascules sont directement en cascade les unes avec les autres, mais les sorties de la dernière bascule sont croisées avant d'être appliquées aux entrées de la première. Les alimentations Vcc et Ve n'ont pas été représentées, ni le circuit logique de sélection 32 qu'il faut rajouter selon l'invention pour produire Ca, Cb, Cc, Cd, Ce, à partir de A, B, C, D, E.

La fig. 4 montre un autre exemple de décade de comptage, réalisée avec des bascules D et non JK; le couplage des bascules n'est pas directement en cascade entre la deuxième et la troisième bascule, mais deux portes NON-OU permettent de déclencher la troisième bascule à partir des états des première, deuxième et troisième bascules; par ailleurs, la première bascule est déclenchée par la sortie complémentée E de la cinquième bascule. Les autres bascules sont directement en cascade.

Comme à la fig. 3, les alimentations et le circuit de sélection 32 n'ont pas été représentés.

## Revendications

1. Unité de comptage non volatile, dont le contenu est mémorisable de manière non volatile après chaque commande d'incrémentation, comprenant plusieurs bascules dont les sorties (A, B, C, D, E) représentent sous forme binaire le contenu de l'unité de comptage, caractérisée en ce que ces bascules sont connectées les unes aux autres de manière que l'état des sorties des bascules représente le contenu du compteur selon un code dans lequel aucun chiffre binaire ne change plus de deux fois au cours d'un cycle de comptage complet de l'unité de comptage, et en ce qu'il est prévu un moyen d'activation sélectif (TR1 à TR5) de la mise en mémoire non volatile des états des sorties des bascules, et un circuit logique de sélection (32) couplé au moyen d'activation pour interdire l'activation de la mise en mémoire de l'état des bascules qui n'ont pas changé d'état après incrémentation de l'unité de comptage et pour autoriser l'activation de la mise en mémoire de l'état des bascules qui ont changé d'état après cette incrémentation.

2. Unité de comptage selon la revendication 1, caractérisée par le fait qu'elle comporte cinq bascules et que le code est un code de Johnson faisant correspondre les états des cinq bascules à un contenu décimal de 0 à 9 du compteur.

3. Unité de comptage selon l'une des revendications 1 et 2, caractérisée par le fait que les bascules comportent chacune au moins un transistor de type MNOS (TM1, TM2) ou un transistor MOS à grille flottante constituant un élément de mémorisation non volatile, que le moyen d'activation de la mise en mémoire est apte à appliquer à ce transistor une tension d'écriture (Ve) plus élevée que la tension normale (Vcc) de fonctionnement de la bascule, et par le fait que le circuit logique de sélection (32) est apte à autoriser ou interdire la transmission de la tension d'écriture aux divers transistors de mémorisation.

4. Unité de comptage selon l'une des revendications 1 à 3, caractérisée par le fait que le circuit logique de sélection reçoit comme entrées les sorties (A, B, C, D, E) des bascules.

5. Unité de comptage selon la revendication 4, caractérisée par le fait que le circuit logique de sélection reçoit également comme entrée un conducteur de remise à 0 du compteur (R).

6. Décade de comptage décimal à cinq bascules selon l'une des revendications 1 à 5, caractérisée par le fait que le circuit logique (32) comporte:
— un circuit de coïncidence (18, 19) recevant les sorties (A et E) de deux des bascules pour fournir un signal d'autorisation de l'activation de la mise en mémoire de l'état de l'une d'elles, et
— quatre circuits d'anticoïncidence (10, 12, 14, 16) recevant chacun les sorties de deux bascules successives pour fournir un signal d'autorisation de l'activation de la mise en mémoire de l'état de l'une d'elles.

7. Décade de comptage décimal selon la revendication 6, caractérisée par le fait que le circuit logique comporte encore des portes OU (20 à 28) recevant chacune sur une entrée le signal d'autorisation engendré par les circuits de coïncidence ou d'anticoïncidence et sur une autre entrée un conducteur de remise à 0 générale (R) de l'unité de comptage, pour autoriser la mise en mémoire non volatile des bascules lors de la remise à 0 forcée de l'unité de comptage.

8. Décade de comptage décimal selon l'une des revendications 1 à 7, caractérisée par le fait que le moyen d'activation comprend des interrupteurs (TR1 à TR5) commandés par le circuit logique, susceptible de relier une source de tension d'écriture (Ve) à chaque bascule.

## Patentansprüche

1. Nichtflüchtige Zähleinheit, deren Inhalt nach jedem Inkrementierbefehl nichtflüchtig speicherbar ist, mit mehreren Kippschaltungen, deren Ausgänge (A, B, C, D, E) den Inhalt der Zähleinheit in Binärform darstellen, dadurch gekennzeichnet, dass diese Kippschaltungen miteinander derart verbunden sind, dass der Zustand der Ausgänge der Kippschaltungen den Inhalt des Zählers gemäss einem Code darstellt, worin keine Binärziffer sich mehr als zweimal im Verlaufe eines vollständigen Zählzyklus der Zähleinheit ändert, und dass Mittel (TR1 bis TR5) zum selektiven Aktivieren der nichtflüchtigen Einspeicherung der Zustände der Ausgänge der Kippschaltungen und eine logische Selektionsschaltung (32) vorgesehen sind, welche an die Aktivierungsmittel angekoppelt ist, um die Aktivierung der Einspeicherung des Zustandes der Kippschaltungen zu unterbinden, deren Zustand sich nach der Inkrementierung der Zähleinheit nicht verändert hat, und um die Aktivierung der Einspeicherung des Zustandes der Kippschaltungen freizugeben, deren Zustand sich nach dieser Inkrementierung verändert hat.

2. Zähleinheit nach Anspruch 1, dadurch gekennzeichnet, dass sie fünf Kippschaltungen umfasst und dass der Code ein Johnson-Code ist, der eine Entsprechung zwischen den Zuständen der fünf Kippschaltungen und einem Dezimalinhalt des Zählers von 0 bis 9 herstellt.

3. Zähleinheit nach einem der Ansprüche 1 und 2, dadurch gekennzeichnet, dass die Kippschaltungen jeweils wenigstens einen Transistor (TM1, TM2) vom MNOS-Typ oder einen MOS-Transistor mit schwimmendem Gate umfassen, welcher ein nichtflüchtiges Speicherelement bildet, dass die Mittel zur Aktivierung der Einspeicherung geeignet sind, um an diesen Transistor eine Schreibspannung (Ve) anzulegen, die höher als die normale Betriebsspannung (Vcc) der Kippschaltung ist, und dass die logische Selektionsschaltung (32) geeignet ist, um die Übertragung der Schreibspannung zu den verschiedenen Speichertransistoren freizugeben oder zu sperren.

4. Zähleinheit nach einem der Ansprüche 1 bis 3, dadurch gekennzeichnet, dass die logische Selektionsschaltung als Eingangssignale die Ausgangssignale (A, B, C, D, E) der Kippschaltungen empfängt.

5. Zähleinheit nach Anspruch 4, dadurch gekennzeichnet, dass die logische Selektionsschaltung ferner als Eingangsgrösse Signale von einem Leiter für die Nullrücksetzung des Zählers (R) empfängt.

6. Dezimale Zähldekade mit fünf Kippschaltungen nach einem der Ansprüche 1 bis 5, dadurch gekennzeichnet, dass die Logikschaltung (32) umfasst:
— eine Koinzidenzschaltung (18, 19), welche die Ausgangssignale (A und E) von zwei Kippschaltungen empfängt, um ein Signal zur Freigabe der Aktivierung der Einspeicherung des Zustandes einer von ihnen zu liefern, und
— vier Antikoinzidenzschaltungen (10, 12, 14, 16), die jeweils die Ausgangssignale der zwei aufeinanderfolgenden Kippschaltungen empfangen, um ein Signal zur Freigabe der Aktivierung der Einspeicherung des Zustandes einer von ihnen zu liefern.

7. Dezimale Zähldekade nach Anspruch 6, dadurch gekennzeichnet, dass die Logikschaltung ferner OR-Torschaltungen (20 bis 28) umfasst, die jeweils an einem Eingang das Freigabesignal empfangen, welches durch die Koinzidenzschaltung oder die Antikoinzidenzschaltung erzeugt wird, und an einem weiteren Eingang ein allgemeines Nullrücksetzsignal (R) für die Zähleinheit empfangen, um die nichtflüchtige Einspeicherung der Kippschaltungen bei der erzwungenen Nullrücksetzung der Zähleinheit freizugeben.

8. Dezimale Zähldekade nach einem der Ansprüche 1 bis 7, dadurch gekennzeichnet, dass die Aktivierungsmittel Unterbrecher (TR1 bis TR5) umfassen, welche durch die Logikschaltung gesteuert werden und geeignet sind, um eine Schreibspannungsquelle (Ve) mit jeder Kippschaltung zu verbinden.

## Claims

1. Non-volatile counting unit whose content is storable in non-volatile manner after each incrementation command, comprising a plurality of latches whose outputs (A, B, C, D, E) represent the content of the counting unit in binary form, characterized in that said latches are connected together in such a manner that the state of the outputs of the latches represents the content of the counter according to a code in which no binary digit changes more than twice in the course of a complete counting cycle of the counting unit, and there are provided selective activation means (TR1 to TR5) for non-volatile entering into the memory of the states of the outputs of the latches and a logical selection circuit (32) coupled to the activation means to disable the activation of the entering into the memory of the state of the latches which have not changed state after the incrementation of the counting unit and to enable the activation of the entering into the memory of the state of the latches which have changed state after said incrementation.

2. Counting unit according to Claim 1, characterized in that it comprises five latches and that the code is a Johnson code establishing correspondence between the states of the five latches and a decimal content of the counter from 0 to 9.

3. Counting unit according to any one of Claims 1 and 2, characterized in that the latches each include at least one transistor (TM1, TM2) of MNOS type or an MOS transistor with floating gate forming a non-volatile storage element, that the means for activation of the entering into the memory are adapted to apply to said transistor a write voltage (Ve) higher than the normal operating voltage (Vcc) of the latch, and that the logic selection circuit (32) is adapted to enable or disable the transmission of the write voltage to the various storage transistors.

4. Counting unit according to any one of Claims 1 to 3, characterized in that the logic selection circuit receives as input signals the output signals (A, B, C, D, E) of the latch circuits.

5. Counting unit according to Claim 4, characterized in that the logic selection circuit also receives input signals from a conductor for the resetting to zero of the counter (R).

6. Decimal counting decade having five latches according to one of Claims 1 to 5, characterized in that the logic circuit (32) comprises:
— a coincidence circuit (18, 19) receiving the output signals (A and E) from two latches in order to furnish a signal for enabling the activation of the entering into the memory of the state of one of them, and
— four anticoincidence circuits (10, 12, 14, 16) each receiving the outputs of two successive latches in order to furnish a signal for enabling the activation of the entering into the memory of the state of one of them.

7. Decimal counting decade according to Claim 6, characterized in that the logic circuit further comprises OR gates (20 to 28) each receiving at an input the enable signal generated by the coincidence circuit or the anticoincidence circuit, and at a further input a general reset to zero signal (R) for the counting unit in order to enable the non-volatile entering into the memory of the latches during the forced resetting to zero of the counting unit.

8. Decimal counting decade according to one of Claims 1 to 7, characterized in that the activation means comprise interrupters (TR1 to TR5) controlled by the logic circuit and able to connect a write voltage source (Ve) to each latch.

Fig.1

0 092 464

Fig.2

0 092 464

Fig.3

Fig.4

13